# FASCICULE DE BREVET EUROPEEN

(11) **EP 3 148 717 B1**
(45) Date de publication et mention de la délivrance du brevet: **11.07.2018**
(21) Numéro de dépôt: 15726119.9
(22) Date de dépôt: 28.05.2015
(51) Int. Cl.: B08B 7/00

(54) **PROCÉDÉ ET DISPOSITIF DE TRAITEMENT PAR FLUIDE DENSE AVEC VOLUME DE STOCKAGE EN DÉCHARGE**
BEHANDLUNGSVERFAHREN UND VORRICHTUNG MIT EINEM VERDICHTETEN FLUID UND EINEM AUSSTOSSSPEICHERVOLUMEN
TREATMENT METHOD AND DEVICE USING A DENSE FLUID AND A DISCHARGE STORAGE VOLUME

(30) Priorité: 28.05.2014 FR 1454886
(43) Date de publication de la demande: 05.04.2017
(73) Titulaire: DFD - Dense Fluid Degreasing, 73370 Le Bourget du Lac (FR)
(72) Inventeur: CHAVRIER, Alain, F-38300 Bourgoin Jallieu (FR)
(74) Mandataire: Brevalex
(86) Numéro de dépôt international: PCT/EP2015/061889
(87) Numéro de publication internationale: WO 2015/181316

(56) Documents cités:
- WO-A1-00/70141
- US-A1- 2004 231 707
- US-A1- 2012 031 431

## Description

### DOMAINE TECHNIQUE ET ÉTAT DE LA TECHNIQUE ANTÉRIEURE

L'invention concerne les techniques de traitement, en particulier d'extraction, par exemple de nettoyage, de pièces ou d'objets par mise en oeuvre d'un fluide dense, par exemple super critique, notamment du dioxyde de carbone.

Une technique de nettoyage est connue du document WO 02/32593-A1 et du document US 2004/023170-A17, qui est considéré comme l'état de la technique le plus proche de l'invention.

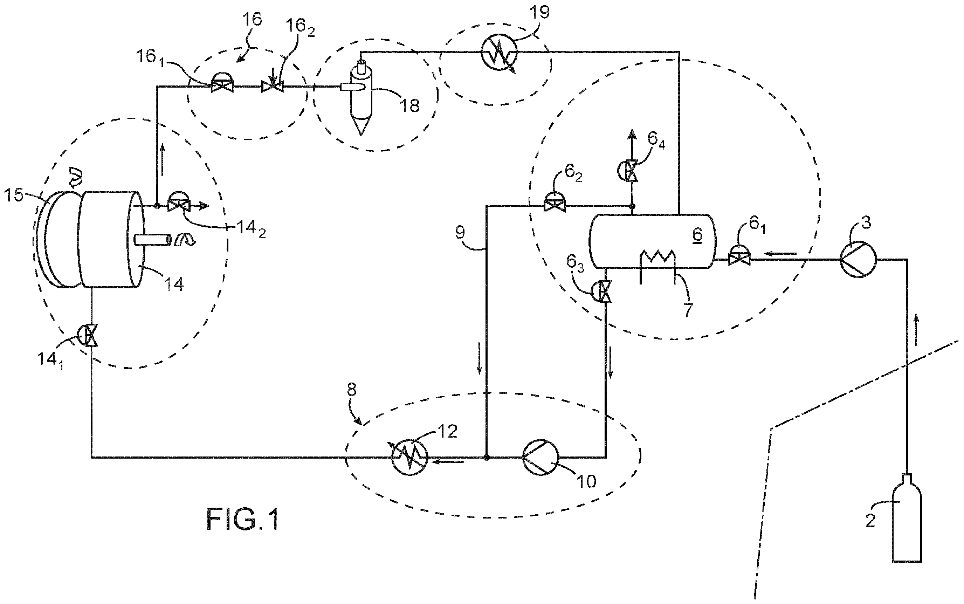

Un dispositif connu, pour mettre en oeuvre une telle technique va être décrit en liaison avec la représentation schématique de la figure 1.

Ce dispositif est alimenté par un gaz liquéfié, qui provient par exemple d'une réserve, ou bouteille, 2, dans laquelle il est maintenu à une température de, par exemple, - 20°C.

Cette réserve 2 permet d'alimenter une enceinte 6 de stockage, qui stocke à la fois du gaz sous forme gazeuse et du gaz liquéfié, via une pompe 3 ou un compresseur de remplissage et une vanne 6₁. Dans cette enceinte, le gaz est chauffé par des moyens 7 de chauffage, ce qui va permettre d'accroître sa température, par exemple à 20° C, et de le porter à une pression de plusieurs dizaines de bar, par exemple environ 60 bars.

Du gaz liquéfié, prélevé à partir de cette enceinte 6 à l'aide d'une vanne 6₃, peut ensuite être porté, par des moyens 8, dans des conditions thermodynamiques lui permettant d'être utilisé comme fluide de nettoyage dans l'enceinte de nettoyage 14, encore appelée autoclave. En particulier, les moyens 8 peuvent comporter des moyens de pompage 10 et des moyens de chauffage 12. Dans le cas où le fluide est du CO₂, la pompe 10 permet de porter le fluide issu de la réserve 6 à une pression supérieure à 73,85 bars, et les moyens de chauffage 12 permettent de porter la température du fluide à une valeur supérieure à 31° C, ces conditions assurant au fluide un état super critique.

Dans l'autoclave, le fluide peut être utilisé conformément à l'enseignement du document WO 02/32193. L'autoclave 14 est muni d'une porte 15 qui va permettre d'y introduire les pièces à nettoyer. Après fermeture de la porte, le fluide est introduit sous pression, à environ 120 bar, et les pièces sont nettoyées par l'action du fluide.

Au cours d'un cycle de nettoyage, le fluide est ensuite évacué, détendu par des moyens 16 de détente (comportant principalement une vanne de régulation 16₂ et une vanne 16₁), puis envoyé vers des moyens 18 formant séparateur, qui vont permettre de séparer le gaz des particules et des salissures qui ont été récupérées lors du nettoyage et dont le gaz est chargé.

Le gaz ainsi traité peut ensuite être amené à des moyens 19 de liquéfaction, puis de nouveau stocké sous forme liquide dans l'enceinte 6.

Un cycle de nettoyage mis en oeuvre avec ce type de dispositif est trop long pour une mise en oeuvre à une échelle réellement industrielle.

Par ailleurs, un tel dispositif consomme trop de gaz.

Plus précisément, lors d'un cycle de nettoyage, après introduction des pièces à nettoyer dans l'autoclave 14 puis fermeture de la porte 15 de celui-ci, mais avant début du cycle de nettoyage, du gaz est introduit dans l'autoclave, à une pression de l'ordre de quelques bars. Ce gaz provient de l'enceinte 6. À cet effet, une vanne 6₂ est disposée sur un trajet défini par un conduit 9 qui relie une partie supérieure de l'enceinte 6 et un point disposé entre la pompe 10 et les moyens de chauffage 12. Cette vanne et ce conduit permettent de prélever du gaz, sous forme gazeuse. Ce gaz est ensuite chauffé par les moyens 12. Si on ne souhaite pas chauffer le gaz, il est possible que le moyen 9 soit relié directement aux moyens 27 ou même directement dans les moyens 14.

Cette étape permet, lorsque le gaz fluide dense est ensuite introduit, sous pression, à partir des moyens 8, d'éviter qu'il ne le soit dans des conditions pouvant conduire à la formation d'un bloc de glace (c'est le phénomène, dans le cas du dioxyde de carbone, de formation de carboglace; en effet, le point triple du CO₂ est à -56°C, 5 bars), ce qui est à éviter car cette glace peut être très difficile à éliminer rapidement.

Mais cette technique conduit :
- à un risque de cavitation de la pompe 10 : du fait de la consommation initiale de gaz, la pression, mais aussi la température, de l'enceinte 6 ont diminué, ce qui peut induire ces problèmes de cavitation ; afin de les limiter au maximum, le volume de l'enceinte 6 doit être le plus grand possible, ce qui est coûteux, ou bien le remplissage de l'enceinte 14 doit être lent, ce qui n'est pas acceptable,
- à une perte de temps, car le gaz ainsi consommé doit être réintroduit dans le système, par exemple par alimentation de l'enceinte 6 à partir de la réserve 2; l'étape de chauffage avec les moyens 7 implique une durée qui augmente la durée d'un cycle de fonctionnement de la machine.

Par ailleurs, en fin de cycle de nettoyage, la porte 15 (ou bien la vanne 14₂) de l'enceinte 14 est ouverte, et le gaz contenu dans cette dernière est envoyé dans l'atmosphère. Il en résulte une perte importante de ce gaz.

Par conséquent, tant du point de vue de la durée de mise en oeuvre d'un cycle, que de la consommation de fluide, un tel dispositif connu ne peut pas être mis en oeuvre à une échelle réellement industrielle.

### EXPOSÉ DE L'INVENTION

L'invention vise à résoudre ces problèmes par un dispositif de traitement par fluide dense, selon la revendication 1 et un procédé de traitement par fluide dense correspondant, selon la revendication 10.

Selon l'invention un dispositif de traitement par fluide dense, par exemple un fluide à l'état super critique, comporte :
a) une enceinte de traitement, encore appelée autoclave, destinée à recevoir des pièces à traiter,
b) des moyens d'alimentation de ladite enceinte de traitement, en fluide dense ou super critique, comportant des premiers moyens de stockage de fluide,
c) des deuxièmes moyens de stockage disposés en sortie de l'enceinte de traitement (encore appelés volume de stockage en décharge),
d) des moyens, par exemple une ou plusieurs vannes, pour mettre en communication fluidique l'enceinte de traitement et lesdits deuxièmes moyens de stockage.

Ainsi est permise une circulation fluidique entre l'enceinte de traitement et lesdits deuxièmes moyens de stockage. Un premier flux de fluide va donc circuler, de l'enceinte de traitement vers lesdits deuxièmes moyens de stockage, puis, inversement, selon un chemin inverse de celui suivi par le premier flux, un deuxième flux de fluide va circuler des deuxièmes moyens de stockage vers l'enceinte de traitement.

Cette circulation se fera par différence de pression entre les 2 volumes concernés : lorsque la pression dans l'enceinte de traitement est supérieure à celle dans les deuxièmes moyens de stockage, le fluide circule de l'enceinte de traitement vers les deuxièmes moyens de stockage ; lorsque la pression dans l'enceinte de traitement est inférieure à celle dans les deuxièmes moyens de stockage, le fluide circule des deuxièmes moyens de stockage vers l'enceinte de traitement.

Des moyens sont spécialement programmés pour faire circuler un fluide de l'enceinte de traitement vers lesdits deuxièmes moyens de stockage, puis, inversement, des deuxièmes moyens de stockage vers l'enceinte de traitement.

Les deuxièmes moyens de stockage permettent de stocker, à une pression P₂, une partie du gaz qui est contenu dans l'enceinte de traitement à pression P₁ (P₁>P₂), après une étape de traitement et avant mise en communication fluidique de l'intérieur de l'enceinte et de l'atmosphère extérieure, notamment par ouverture de la porte de l'enceinte et avant mise en communication fluidique de l'enceinte de traitement avec les moyens de stockage.

Ici et dans toute la suite, l'expression «mise en communication fluidique», s'appliquant à 2 volumes, signifie qu'un fluide peut circuler, ou s'écouler, d'un volume à l'autre. Les moyens de mise en communication fluidique sont également des moyens pour interrompre cette communication fluidique, c'est-à-dire pour stopper toute possibilité d'écoulement de fluide d'un volume à l'autre.

Le transfert de gaz, entre les deuxièmes moyens de stockage et l'enceinte de traitement, dans un sens ou dans l'autre, est réalisé à l'aide des moyens de mise en communication fluidique, par exemple par ouverture d'une ou plusieurs desdites vannes. Ce transfert est réalisé sans moyens de pompage, sous la simple action de la pression dans les deux volumes mis en communication, par exemple jusqu'à équilibrage des pressions entre ces 2 volumes.

L'invention permet une récupération d'une partie du gaz utilisé, sans apport énergétique, et sans pièces en mouvement, hormis les vannes.

Les deuxièmes moyens de stockage sont différents des premiers moyens de stockage. Ils peuvent en outre être différents des premiers moyens de stockage par leur volume, et/ou la pression à laquelle les gaz y sont stockés...etc.

Les deuxièmes moyens de stockage permettent ensuite une réutilisation du gaz stocké pour diverses applications.

En particulier, une partie du fluide ainsi stocké peut être réutilisée, en début de cycle de traitement suivant, en étant réinjectée dans l'enceinte de traitement. Cette étape:
- est réalisée après chargement de pièces ou de matériau à traiter dans l'enceinte de traitement, puis isolation de l'intérieur de l'enceinte par rapport à l'atmosphère extérieure, notamment par fermeture des moyens de communication fluidique entre l'intérieur de l'enceinte et l'atmosphère extérieure, en particulier de la porte de cette enceinte, mais avant introduction de fluide dense et avant début du traitement,
- conduit à une répartition du gaz stocké dans lesdits deuxièmes moyens de stockage, à la fois dans ces moyens de stockage et dans ladite enceinte de traitement, à une pression P₃ inférieure à la pression P₂ de stockage dans les moyens de stockage.

Pour la mise en oeuvre de cette étape, on actionne les moyens de mise en communication fluidique, comme indiqué ci-dessus.

La pression dans l'enceinte de traitement s'accroit alors, de la pression atmosphérique à une pression P₃, inférieure à la pression P₂ de stockage dans les deuxièmes moyens de stockage, tandis que la pression dans les deuxièmes moyens de stockage diminue, de la pression P₂ de stockage à, par exemple, la pression P₃.

Ce remplissage en gaz de l'autoclave, en début du cycle de nettoyage, peut être très rapide.

En outre, cette possibilité permet d'avoir un volume de stockage principal plus faible.

Par ailleurs, une partie de ce fluide ainsi stocké peut être utilisée pour actionner au moins une partie des éléments à commande pneumatique du système. On économise ainsi un autre fluide (par exemple de l'air comprimé) habituellement utilisé pour actionner lesdits éléments pneumatiques (vanne et/ou vérin et/ou pompe).

Pour cette raison, un dispositif selon l'invention peut comporter des moyens pour amener au moins une partie du fluide stocké dans les deuxièmes moyens de stockage vers une ou plusieurs vannes (et/ou vérins et/ou pompes) à commande pneumatique.

Enfin, une partie de ce fluide ainsi stocké peut être comprimée, liquéfiée et injectée dans les premiers moyens de stockage de fluide.

A cet effet, un dispositif selon l'invention peut en outre comporter des moyens pour amener au moins une partie du fluide stocké dans les deuxièmes moyens de stockage vers les moyens d'alimentation de ladite enceinte de traitement (ou vers les premiers moyens de stockage), de préférence pendant un cycle de traitement.

Un autre avantage, lié au stockage du fluide qui reste dans l'enceinte de traitement en fin de cycle, est le suivant. L'évacuation rapide de l'enceinte en fin de cycle a pour conséquence immédiate le dégagement, dans l'atmosphère, du fluide qu'elle contient au moment de cette évacuation. Ce dégagement rapide s'accompagne d'un niveau sonore élevé. Du fait du transfert d'une partie du gaz de l'enceinte de traitement vers les deuxièmes moyens de stockage, avant évacuation de l'enceinte, la quantité de gaz dégagé dans l'atmosphère est réduite, ce qui entraîne une réduction du volume sonore lié à cette étape, par rapport au cas où aucun volume de gaz de l'enceinte de traitement n'est transféré dans des moyens de stockage externes à l'enceinte.

Les deuxièmes moyens de stockage peuvent avoir un volume interne inférieur à, ou supérieur à, ou identique à, ou voisin de, celui de l'enceinte de traitement, par exemple égal à ce dernier +10 %. L'efficacité augmente avec la taille de ces deuxièmes moyens de stockage. Les deuxièmes moyens de stockage peuvent être disposés :
- en parallèle, ou en sortie, de moyens qui permettent de détendre un gaz en sortie de ladite enceinte,
- et /ou, dans le sens de circulation de fluide à partir de ladite enceinte, en amont de moyens formant séparateur.

Des moyens peuvent être prévus pour chauffer les deuxièmes moyens de stockage, afin que le gaz qui y est stocké ne se liquéfie pas.

L'invention concerne également un procédé de traitement par fluide dense, mettant en oeuvre un dispositif selon l'invention, en particulier de type tel que décrit ci-dessus.

L'invention concerne également un procédé de traitement par fluide dense, éventuellement super critique, selon la revendication 10, comportant :
a) l'introduction d'au moins une 1^{ère} pièce à traiter, dans une enceinte, munie d'une porte d'ouverture et de fermeture (ou, plus généralement, de moyens pour mettre en communication fluidique l'enceinte et l'atmosphère extérieure), puis la fermeture de cette porte (ou, plus généralement, l'arrêt ou la fermeture de la communication fluidique entre l'enceinte et l'atmosphère extérieure),
b) l'alimentation de ladite enceinte en fluide dense et le traitement de ladite pièce,
c) le stockage, dans des moyens de stockage, à une pression P₂ inférieure à celle, P₁, qui existe dans l'enceinte, après l'étape b) de traitement et avant l'ouverture de la porte de l'enceinte (ou, plus généralement, avant la mise en communication fluidique de l'enceinte et de l'atmosphère extérieure), d'une partie du gaz contenu dans l'enceinte,
d) puis l'ouverture de ladite porte, ou, plus généralement, la mise en communication fluidique de l'enceinte et de l'atmosphère extérieure.

Un tel procédé peut ensuite en outre comporter, dans cet ordre :
e) l'introduction d'au moins une deuxième pièce à traiter dans ladite enceinte, puis la fermeture de ladite porte (ou, plus généralement, l'arrêt ou la fermeture de la communication fluidique entre l'enceinte et l'atmosphère extérieure),
f) puis l'injection, dans ladite enceinte, d'au moins une partie du gaz stocké dans lesdits moyens de stockage, le gaz contenu dans ladite enceinte étant alors à une pression Pa inférieure à la pression Ps de stockage dans les moyens de stockage.

Une circulation fluidique a donc lieu entre l'enceinte de traitement et lesdits deuxièmes moyens de stockage. Un premier flux de fluide circule, de l'enceinte de traitement vers lesdits deuxièmes moyens de stockage, puis, inversement, selon un chemin inverse de celui suivi par le premier flux, un deuxième flux de fluide circule des deuxièmes moyens de stockage vers l'enceinte de traitement.

Cette circulation résulte de la différence de pression entre les 2 volumes concernés : lorsque la pression dans l'enceinte de traitement est supérieure à celle dans les deuxièmes moyens de stockage, le fluide circule de l'enceinte de traitement vers les deuxièmes moyens de stockage ; lorsque la pression dans l'enceinte de traitement est inférieure à celle dans les deuxièmes moyens de stockage, le fluide circule des deuxièmes moyens de stockage vers l'enceinte de traitement.

Un procédé de traitement par fluide dense, éventuellement super critique, non couverts par l'invention, peut comporter:
a) l'introduction d'au moins une 1^{ère} pièce à traiter, dans une enceinte, munie d'une porte d'ouverture et de fermeture (ou, plus généralement, de moyens pour mettre en communication fluidique l'enceinte et l'atmosphère extérieure), puis la fermeture de cette porte (ou, plus généralement, l'arrêt ou la fermeture de la communication fluidique entre l'enceinte et l'atmosphère extérieure),
b) l'alimentation de ladite enceinte en fluide dense et le traitement de ladite pièce,
c) le stockage, dans des (deuxième) moyens de stockage, à une pression P₂ inférieure à celle, P₁, qui existe dans l'enceinte, après l'étape b) de traitement et avant l'ouverture de la porte de l'enceinte (ou, plus généralement, avant la mise en communication fluidique de l'enceinte et de l'atmosphère extérieure), d'une partie du gaz contenu dans l'enceinte,
d) puis, ultérieurement, une circulation fluidique depuis lesdits deuxièmes moyens de stockage vers l'enceinte de traitement.

Un premier flux de fluide va donc circuler, de l'enceinte de traitement vers lesdits deuxièmes moyens de stockage, puis, inversement, selon un chemin inverse de celui suivi par le premier flux, un deuxième flux de fluide va circuler des deuxièmes moyens de stockage vers l'enceinte de traitement.

Un tel procédé peut comporter en outre une injection ou un transfert d'une partie du gaz stocké dans lesdits moyens de stockage (ou deuxièmes moyens de stockage) dans des moyens de stockage principaux, (ou premiers moyens de stockage) disposés en amont de moyens pour amener un fluide dans un état super-critique. De préférence, cette injection a lieu au moins en partie pendant un cycle de traitement.

Un procédé selon l'invention peut en outre comporter l'actionnement d'un ou plusieurs éléments à commande pneumatique à l'aide d'une partie du gaz stocké dans lesdits moyens de stockage.

Il est possible de chauffer les deuxièmes moyens de stockage, afin que le gaz qui y est stocké ne se liquéfie pas.

Les (deuxièmes) moyens de stockage et les moyens d'injection peuvent être disposés en parallèle de moyens qui permettent de détendre un gaz en sortie de ladite enceinte.

Ces (deuxièmes) moyens de stockage et lesdits moyens d'injection peuvent être disposés en sortie de moyens qui permettent de détendre un gaz en sortie de ladite enceinte.

Dans un procédé selon l'invention, la pièce à traiter peut être au moins en partie en un matériau métallique, et/ou en un alliage métallique, et/ou en matériau céramique, et/ou en un matériau semi-conducteur, et/ou en un matériau textile et/ou en un matériau naturel.

Le traitement peut être un traitement d'extraction, par exemple de nettoyage (l'enceinte est alors une enceinte de nettoyage) ou de dégraissage, ou de déliantage, ou de stérilisation, ou d'imprégnation, ou de dépôt.

Un dispositif selon l'invention, tel que défini ci-dessus, est commandé, ou un procédé selon l'invention, tel que défini ci-dessus, est commandé ou mis en oeuvre, par des moyens spécialement programmés pour faire circuler un fluide de l'enceinte de traitement vers les deuxièmes moyens de stockage, puis, inversement, ou selon un trajet inverse, des deuxièmes moyens de stockage vers l'enceinte de traitement.

### BRÈVE DESCRIPTION DES DESSINS

- La figure 1 est un schéma d'une machine de nettoyage à fluide super critique, de type connu,
- La figure 2 est un schéma d'un mode de réalisation d'une machine de nettoyage à fluide super critique, selon l'invention,
- La figure 3 est un schéma d'un autre mode de réalisation d'une machine de nettoyage à fluide super critique, selon l'invention,
- Les figures 4A et 4B sont des variantes d'une machine de nettoyage à fluide super critique, selon l'invention,
- la figure 5 est une représentation schématique des moyens de contrôle d'une machine selon l'invention.

### EXPOSÉ DÉTAILLÉ DE MODES DE RÉALISATION PARTICULIERS

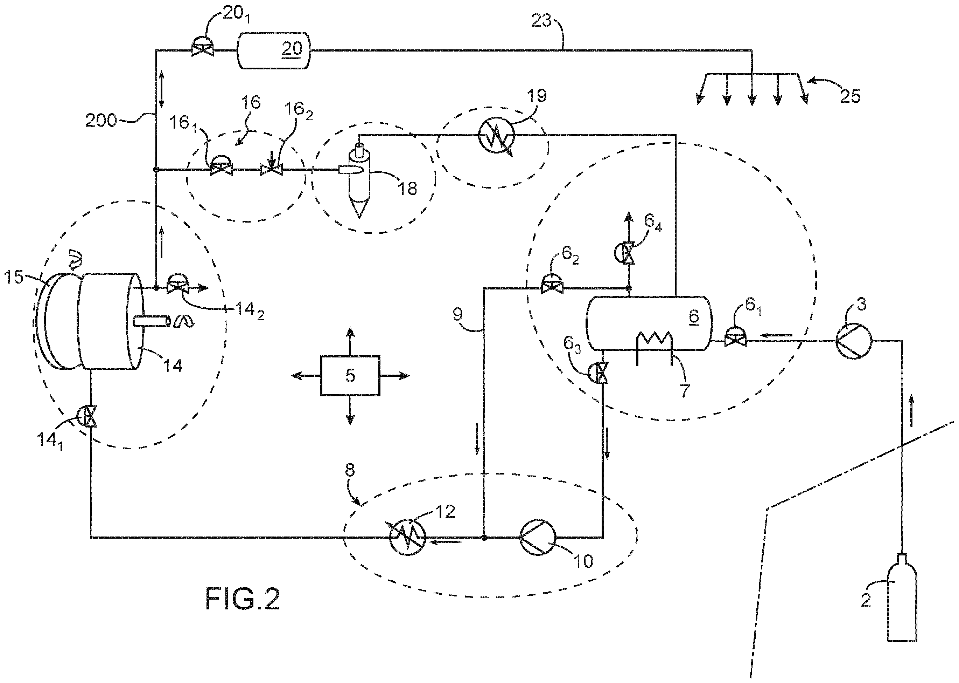

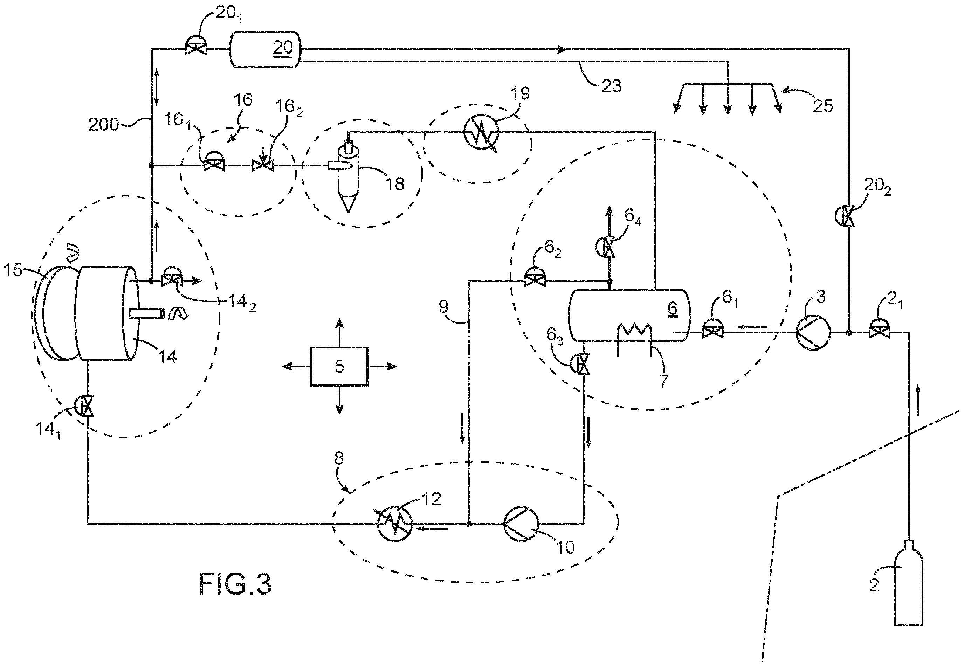

On a représenté, en figures 2 et 3, un exemple de réalisation d'une machine selon l'invention.

Des références numériques identiques à celles de la figure 1 y désignent des éléments identiques ou correspondants. En particulier, cette machine comporte une enceinte 6 de stockage (ou premiers moyens de stockage), prévue pour stocker du gaz liquéfié, à plusieurs dizaine de bars, par exemple 60 bars. Cette enceinte peut être alimentée par une réserve 2, qui a par exemple la forme d'une cuve (qui contient du gaz et aussi éventuellement du gaz liquéfié à, par exemple, 20 bars), à laquelle le dispositif peut être relié, et par des moyens de liquéfaction (non représentés sur les figures) pouvant être prévus en sortie de cette réserve, pour former un gaz liquéfié qui est ensuite stocké dans l'enceinte 6.

Un autoclave 14, ou enceinte de nettoyage, accueille les pièces à nettoyer. Cette enceinte est munie d'une porte 15, par laquelle les pièces peuvent être introduites dans l'enceinte, puis, après nettoyage, extraites de l'enceinte. Elle peut également être munie d'un évent, ou d'un conduit formant évent, et d'une vanne 14₂. Des moyens pour, éventuellement, mettre en mouvement cet autoclave, ainsi que des moyens pour accueillir des paniers qui vont contenir des pièces à nettoyer, sont décrits dans le document WO 02/32593.

Des moyens 8, comportant par exemple une pompe 10 et des moyens 12 de chauffage permettent d'amener le fluide, prélevé dans l'enceinte 6, dans des conditions thermodynamiques lui permettant d'être utilisé comme fluide de nettoyage dans l'enceinte de nettoyage 14. Dans le cas où le fluide est du CO₂, la pompe 10 permet de porter le fluide issu de la réserve 6 à une pression supérieure 73,85 bars, et les moyens de chauffage 12 permettent de porter la température du fluide à une valeur supérieure à 31° C, ces conditions assurant alors au fluide un état dit super-critique.

Des moyens 16 permettent de détendre le gaz en sortie de l'autoclave 14.

Des moyens 18, formant séparateur, permettent de séparer le gaz des impuretés qu'il transporte et qui résultent d'une opération de nettoyage précédente ou en cours.

L'ensemble de ces moyens permet de réaliser un cycle de nettoyage, c'est-à-dire un ensemble d'étapes, qui comprennent principalement :
a) le chargement des pièces dans l'autoclave 14,
b) la fermeture de la porte 15, et éventuellement de la vanne 14₂ (ou, plus généralement, l'arrêt ou la fermeture de la mise en communication fluidique de l'enceinte et de l'atmosphère extérieure),
c) le nettoyage des pièces par l'action du fluide dense sur les pièces à nettoyer ; cette étape est réalisée à forte pression P₀, par exemple supérieure à 100 bars, par exemple encore à environ 120 bars pour du CO₂ super-critique,
d) après nettoyage, la réduction de la pression dans l'enceinte, de P₀ à une valeur P₁, sensiblement inférieure à P₀; P₁ est par exemple de l'ordre de quelques dizaines de bar, ou encore comprise entre 50 bars et 90 bar, ou encore entre 60 et 70 bar, par exemple voisin de la pression dans le stockage 6.
e) l'ouverture de la porte (ou, plus généralement, la mise en communication fluidique de l'enceinte et de l'atmosphère extérieure), et le déchargement des pièces; le volume interne de l'autoclave est alors à pression atmosphérique.

Mais le dispositif comporte ici, en outre, des deuxièmes moyens 20 de stockage (ou volume de stockage, différent de chacun des moyens 6, 18) qui vont permettre de stocker une partie du gaz qui est contenu dans l'autoclave 14 en fin du cycle de nettoyage, avant ouverture de la porte 15 (étape e) (ou, plus généralement, avant la mise en communication fluidique de l'enceinte et de l'atmosphère extérieure), à la pression P₁ indiquée ci-dessus. Ces 2 volumes sont reliés par un conduit 200. Le gaz n'est alors plus dans les conditions lui permettant d'être à l'état dense, ou, pour du CO₂, super critique. Un jeu de vannes 16₁, 20₁ va permettre de diriger, pendant une durée prédéterminée, le flux de gaz en provenance de l'autoclave 14 vers ces moyens 20 de stockage via le conduit 200 qui les relie. Ces moyens 20 peuvent en outre être munis de moyens de mesure de pression.

Dans le mode de réalisation de la figure 3, en sortie de ces moyens 20, des moyens 20₂, par exemple une vanne, permettent d'envoyer une partie du gaz stocké dans les moyens 20, en aval, vers les moyens d'alimentation de l'enceinte 6. Lors de l'opération de remplissage des moyens 20, ces moyens 20₂ seront de préférence fermés.

De préférence, les moyens 20 ont un volume interne supérieur ou égal, au volume interne de l'autoclave 14. Ce volume est par exemple de l'ordre de quelques dizaines de litres, par exemple compris entre 50 l et 100 l. Par exemple encore, pour un autoclave dont le volume interne est d'environ 85 l, le volume interne des moyens 20 peut être également d'environ 85 l.

Si l'enceinte 14 a pour volume interne Vₐ, et si les moyens 20 ont pour volume interne Vᵣ, alors la proportion de gaz stocké, et donc économisé, dans les moyens 20 tend vers Vᵣ/(Vₐ+2Vᵣ), après ouverture complète de la vanne 20₁. Ce volume tend vers 50% pour un volume Vr très grand par rapport à Va, et vers 33% si Vr = Va. On a donc intérêt à avoir un volume des moyens 20 qui aient une capacité de stockage la Plus grande possible, mais il faut bien sûr viser un optimum économique.

Ces moyens 20 de stockage peuvent être disposés en parallèle des moyens 16 de détente du gaz qui sort de l'autoclave. Le trajet suivi par les gaz en sortie d'autoclave dépend de l'actionnement des vannes 16₁, 20₁ : si la vanne 16₁ est ouverte, le gaz est envoyé vers les moyens 16 de détente, et poursuit son trajet habituel, vers les moyens 18 formant séparateur. Lorsque cette vanne 16₁ est ouverte, la vanne 20₁ est fermée. L'ouverture de cette dernière est précédée de la fermeture de la vanne 16₁. Temporairement, le gaz n'est alors plus dirigé vers les moyens de détente, mais vers les moyens 20 de stockage. Lors de l'injection de gaz, depuis les moyens 20 vers l'autoclave 14, on ferme la vanne 16₁ et on ouvre la vanne 20₁. Généralement, on ferme la vanne 16₁ et on ouvre la vanne 20₁ sauf si on veut utiliser le gaz du réservoir 20 pour pré remplir les volumes 18 et éventuellement 6.

À l'issue du remplissage des moyens 20, de la manière expliquée ci-dessus, la pression P₂ dans l'autoclave 14, avant ouverture de la vanne 14₁, peut-être, par exemple, sensiblement identique à celle atteinte dans les moyens 20 de stockage. Comme déjà indiqué ci-dessus, cette pression est sensiblement inférieure à la pression P₁ obtenue habituellement en fin de cycle de nettoyage (par exemple environ 60 bar), avant ouverture de la porte 15. Par exemple, P₂ est comprise entre, d'une part, P₁ et, d'autre part, P₁/2.

Plus généralement, si l'enceinte 14 a pour volume interne Vₐ, et si les moyens 20 ont pour volume interne Vᵣ, alors la pression obtenue après ouverture complète de la vanne 20₁ est comprise entre P₁Vₐ/(Vₐ+Vᵣ) au premier cycle (Vᵣ est alors initialement, ou avant le 1er cycle, vide) et P₁(Vₐ+Vᵣ)/(Vₐ+2Vᵣ) après un grand nombre de cycles. Par conséquent, le gaz, qui est dans l'autoclave 14 en fin de cycle de nettoyage, passe successivement :
- d'abord de la pression P₁ à la pression P₂ (pression qui peut être sensiblement identique dans l'autoclave 14 et dans les moyens 20), qui est inférieure à la pression P₁, et qui peut être comprise dans la gamme mentionnée ci-dessus,
- puis, lorsqu'il est réinjecté, à partir des moyens 20, dans l'autoclave 14 qui est alors à la pression atmosphérique, de la pression P2 à une pression P3, qui est elle-même inférieure à la pression P2 ; la pression obtenue après ouverture complète de la vanne 20₁ est P₂Vᵣ/(Vₐ+Vᵣ).

On note également que le passage d'une première pression P₁ (respectivement P₂) à une deuxième pression P₂ (respectivement P₃), inférieure à la première, ne nécessite aucun détendeur, la détente étant assurée par la répartition du gaz depuis un premier volume vers un volume global qui est supérieur au premier volume. En d'autres termes : le volume total constitué par l'enceinte 14 et les moyens 20 est supérieur, d'une part, au seul volume de l'enceinte 14 et, d'autre part, au seul volume des moyens 20 ; la mise en communication entre les 2 volumes assure, en fonction de la durée d'ouverture des vannes, la répartition du gaz entre eux et, tout au plus, l'équilibrage des pressions entre eux.

Après répartition des gaz entre l'enceinte 14 et les moyens de stockage 20, puis fermeture de la vanne 20₁, il est possible d'ouvrir la vanne 14₂ (ou la porte 15) de l'autoclave, afin de libérer le reste du gaz de nettoyage que ce dernier contient encore. La pression dans l'autoclave est ainsi ramenée à la pression atmosphérique (étape e) ci-dessus). Le gaz, qui a été accumulé dans les moyens 20 de stockage, reste alors stocké dans ces derniers et n'en est pas évacué.

Un remplissage initial des moyens 20 peut être réalisé à la fin d'un premier cycle de nettoyage, par ouverture de la vanne 20₁, le gaz se répartissant alors entre les deux volumes 14, 20, puis fermeture de cette même vanne. Il est alors possible d'ouvrir la vanne 14₂, puis la porte 15.

Lors d'un cycle de nettoyage suivant, après introduction des pièces à nettoyer dans l'autoclave 14 (étape a), et après fermeture de la porte 15 (étape b) de celui-ci (ou, plus généralement, après l'arrêt ou la fermeture de la mise en communication fluidique de l'enceinte et de l'atmosphère extérieure), mais avant introduction de fluide dense dans l'autoclave 14, une partie du gaz accumulé dans les moyens 20 peut être introduit dans l'autoclave, par ouverture de la vanne 20₁. Une partie du gaz stocké dans les moyens 20 revient donc vers l'enceinte 14, suivant un trajet inverse de celui suivi par le gaz lorsqu'il a migré de l'enceinte 14 vers les moyens 20. Ce gaz repasse donc par le conduit 200, mais en sens inverse. La quantité exacte dépend du degré d'ouverture de cette dernière et de sa durée d'ouverture. Par exemple, l'autoclave est rempli avec ce gaz à une pression de l'ordre de quelques bars, par exemple encore comprise entre 5 et 15 bars ou même 10 bars ou même plus.

Cette étape permet, lorsque le gaz fluide dense est introduit, sous pression, à partir des moyens 8, d'éviter qu'il ne le soit dans des conditions pouvant conduire à la formation d'un bloc de glace (c'est le phénomène, dans le cas du dioxyde de carbone, de formation de carboglace), ce qui est à éviter car cette glace peut être très difficile à éliminer rapidement.

Par conséquent, selon cette technique, on utilise une partie du gaz stocké dans les moyens de stockage 20 lors d'un cycle de nettoyage précédent, pour le réinjecter dans l'autoclave 14 lors, ou au début, du cycle de nettoyage suivant. Ceci permet de réutiliser une partie du gaz qui a déjà été utilisé lors du cycle précédent. En outre, cette étape est quasiment instantanée, par simple ouverture de la vanne 20₁. Aucune pompe, ni aucune étape de pompage, n'est nécessaire, pour introduire le gaz, qui provient de l'autoclave 14, dans les moyens 20 de stockage et, réciproquement, pour renvoyer le gaz stocké dans ces derniers vers l'autoclave 14, en début du cycle de nettoyage suivant.

L'invention permet de réaliser un cycle de nettoyage qui comporte les étapes suivantes:
a) le chargement des pièces dans l'autoclave 14,
b) la fermeture de la porte 15 (ou, plus généralement, l'arrêt de la mise en communication fluidique, ou la fermeture des moyens de mise en communication fluidique, de l'enceinte et de l'atmosphère extérieure), le volume intérieur de l'autoclave 14 étant alors à pression atmosphérique,
b₁) l'injection de gaz dans l'autoclave 14, à partir des moyens 20; ou, plus précisément, la mise en communication fluidique de l'enceinte 14 avec les moyens de stockage 20, accompagné du transfert d'une partie du gaz contenu dans les moyens de stockage 20 vers l'enceinte 14 et d'une variation de pression entre ces 2 volumes (la pression dans l'enceinte 14 s'accroit, tandis que la pression dans les moyens 20 diminue), puis l'isolation de l'enceinte 14 par rapport aux moyens de stockage 20,
c) puis l'introduction, dans l'autoclave 14, de fluide dense, et le nettoyage des pièces par action de ce fluide dense sur les pièces à nettoyer; cette étape est réalisée à forte pression P₀, par exemple supérieure à 100 bars, par exemple encore à environ 120 bars pour du CO₂ super-critique,
d) la réduction de la pression dans l'enceinte, de P₀ à une valeur P₁, sensiblement inférieure à P_{0;} P₁ est par exemple de l'ordre de quelques dizaines de bar, ou encore comprise entre 50 bars et 90 bar, ou encore entre 60 et 70 bars,
d₁) la mise en communication fluidique de l'enceinte 14 avec les moyens de stockage 20, accompagnée du transfert d'une partie du gaz contenu dans l'enceinte 14 vers les moyens de stockage 20, et de la variation de pression entre ces 2 volumes (la pression dans l'enceinte 14 diminue, tandis que la pression dans les moyens 20 s'accroit), puis l'isolation de l'enceinte 14 par rapport aux moyens de stockage 20,
e) enfin, l'ouverture de la porte (ou, plus généralement, mise en communication fluidique de l'enceinte et de l'atmosphère extérieure) et déchargement des pièces ; le volume interne de l'autoclave est alors à pression atmosphérique.

On peut noter que, pendant l'étape c), le fluide dense peut être introduit dans l'autoclave continument par les moyens 20; en sortie d'autoclave, il peut être détendu par les moyens 16, nettoyé par les moyens 18, liquéfié par les moyens 19 et renvoyé dans les moyens 6 pour être réutilisé ; ceci peut être répété ou mis en oeuvre continument jusqu'à la fin du traitement. Du fluide dense peut donc être recyclé continuellement.

Le fait de stocker dans les moyens 20 une partie du gaz, disponible en fin de cycle dans l'autoclave 14, permet également de réduire la quantité de gaz qui va s'échapper de ce dernier lors de l'ouverture de la vanne 14₂ (étape e). Cela conduit, notamment, à une réduction de l'effet acoustique, donc, pratiquement, à une réduction du bruit, qui accompagne l'échappement du gaz de l'enceinte.

Une partie du gaz stocké dans les moyens 20 peut en outre être utilisée pour faire fonctionner les éléments pneumatiques utilisés dans le système. Ce dernier peut en effet comporter :
- une ou des vannes pneumatiques,
- et/ou un ou des vérins pneumatiques, notamment pour la manutention des pièces à traiter, lors du chargement et du déchargement de l'enceinte 14, ou encore pour ouvrir ou fermer la porte 15,
- et/ou une ou des pompes pneumatiques.

Plus généralement, tous les moyens qui mettent habituellement en oeuvre une alimentation en gaz supplémentaire, par exemple de l'air comprimé, peuvent être actionnés par du gaz stocké dans les moyens 20. Par exemple, les vannes sont habituellement mises en oeuvre avec une alimentation en air comprimé. L'utilisation, à cette fin, du gaz stocké dans les moyens 20, permet d'éliminer la nécessité d'un approvisionnement d'un tel gaz supplémentaire. Dans ce but, un conduit 23 permet de prélever du gaz des moyens 20 ; des canaux de distribution, désignés globalement par la référence 25 sur la figure 2, emmènent ce gaz prélevé vers, par exemple, les différentes moyens pneumatiques du système, notamment une ou des vannes et/ou un ou des vérins et/ou une ou des pompes. Un détendeur peut être prévu en sortie des moyens 20, sur le conduit 23, afin de réduire la pression en vue de ces applications.

Cet aspect est avantageux par rapport à une situation où du gaz serait prélevé des moyens 6 pour alimenter un ou des moyens pneumatiques. Dans ce dernier cas, en effet, toute fuite de l'alimentation en fluide comprimé d'une vanne ou d'un élément pneumatique va entraîner une fuite d'une quantité égale, au maximum, à la quantité contenue dans les moyens 6. Dans la solution proposée ici (alimentation en gaz à partir des moyens 20), la quantité de gaz contenue dans les moyens 20, est en général très inférieure à celle dans les moyens 6.

Enfin, selon le schéma de la figure 3, il est possible d'utiliser une partie du gaz stocké dans les moyens 20 pour le réinjecter dans le circuit usuel. Du gaz provenant des moyens 20 peut donc ensuite être réinjecté, sous forme de gaz liquéfié, dans les moyens 6, après avoir subi une compression par le compresseur 3 et éventuellement une liquéfaction sous l'action des moyens 7. Cette étape peut être réalisée pendant la mise en oeuvre d'un cycle de traitement, en temps masqué.

Le dispositif et le procédé qui ont été décrits ci-dessus conviennent particulièrement à la mise en oeuvre d'un nettoyage par du dioxyde de carbone à l'état super-critique. Néanmoins, ce dispositif peut également être adapté pour un fonctionnement avec un autre fluide, par exemple un fluide dense sous pression, ou, par exemple encore, avec de l'oxygène ou de l'azote, dans des conditions leur permettant d'être à l'état super-critique (pour l'oxygène : au-delà de -119°C et 50 bars ; pour l'azote : au-delà de -147° C et 34 bar)

En variante, un autre fluide peut être mis en oeuvre, par exemple un fluide parmi le méthane, l'éthanol, le propane, le protoxyde d'azote, un gaz fluoré, l'ammoniaque, l'alcool, l'éthanol, l'isopropanol, l'eau.

Par ailleurs, en combinaison avec l'un des fluides déjà mentionnés ci-dessus, un additif tel un solvant peut également être introduit dans l'enceinte 14.

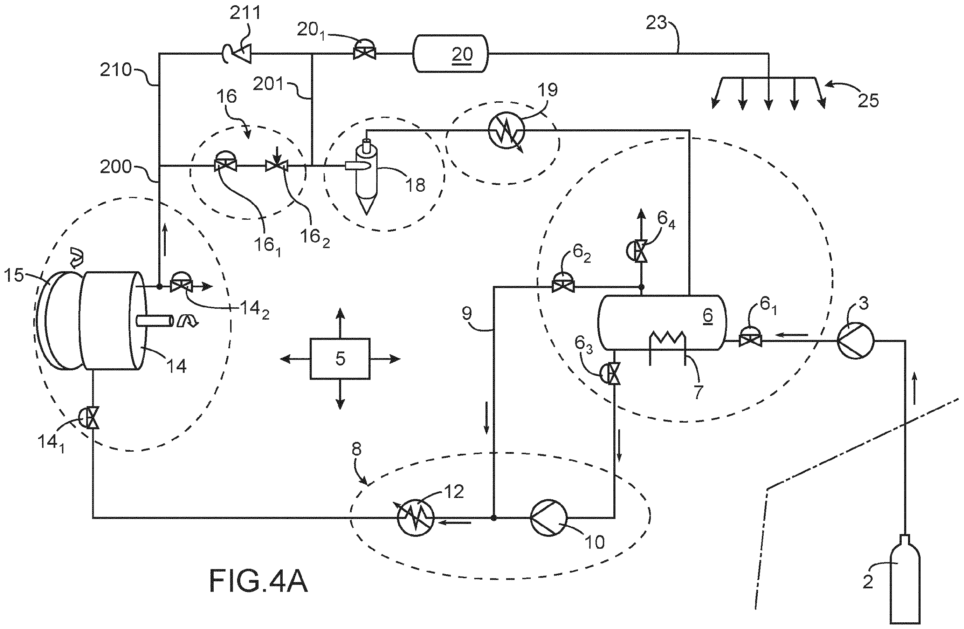

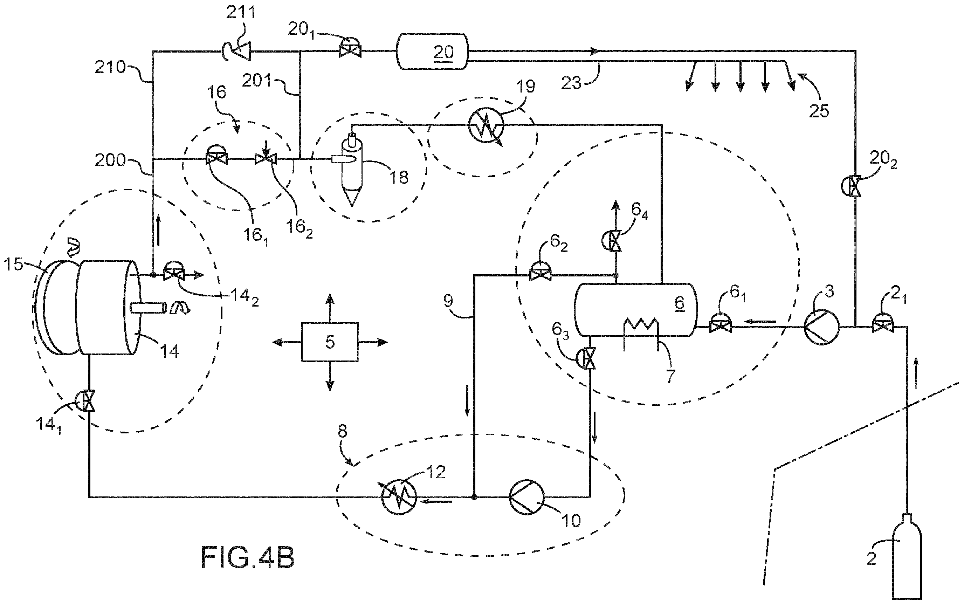

Les figures 4A et 4B sont des variantes, respectivement des machines des figures 2 et 3 décrites ci-dessus, dans lesquelles le réservoir 20 est alimenté à partir d'un point disposé entre la vanne de régulation 16₂ et le séparateur 18. Le gaz migre de l'enceinte 14 vers les moyens 20 via plusieurs conduits 200, 201. Ceci permet de dimensionner le réservoir pour une pression, par exemple 60 bar, moins élevée que dans les modes de réalisation précédents, car il est protégé contre une surpression par les moyens 16₁, 16₂ et par les moyens 18 au cas où, par exemple, la vanne 20₁ resterait ouverte pendant le fonctionnement d'un cycle de traitement. Là encore, une partie du gaz stocké dans les moyens 20 revient vers l'enceinte 14, suivant un trajet inverse de celui suivi par le gaz lorsqu'il a migré de l'enceinte 14 vers les moyens 20. Ce gaz repasse donc par les mêmes conduits 200, 201 mais en sens inverse.

Un conduit 210 peut relier la sortie de l'enceinte 14 (ou un point en amont des moyens 16, dans le sens d'écoulement du fluide à partir de l'enceinte 14) et l'entrée des moyens 20 ou de la vanne 20₁. Ce conduit peut être muni de moyens 211 formant clapet anti-retour, qui bloquent un écoulement direct du fluide à partir de l'enceinte 14 vers les moyens 20, mais permettent un écoulement depuis les moyens 20 vers l'enceinte 14. Ainsi, un fluide qui s'écoule à partir de l'enceinte 14 passe forcément par les moyens 16 ; mais l'inverse n'est pas vrai, un écoulement depuis les moyens 20 vers l'enceinte 14 pouvant passer par le conduit 210, pour rejoindre le conduit 200.

Un exemple comparatif va être donné.

On considère d'abord un cycle d'une machine telle que celle de la figure 1 (machine standard, avec une enceinte de stockage 6 sous pression de 60 bars). Le cycle est le suivant.

Toutes les vannes sont d'abord supposées fermées, puis la porte de l'autoclave est ouverte. La réserve interne 6 est suffisamment pleine. Les étapes du cycle sont les suivantes.
1. Fermeture de la porte 15 de l'autoclave 14 et de la vanne 14₂, l'autoclave 14 est donc à la pression atmosphérique.
2. Ouverture de la vanne 6₂ pour commencer à remplir l'autoclave 14 avec du CO₂ gazeux.
3. Quand la pression dans l'autoclave 14 est de l'ordre de 10 bars (ou plus), on ferme la vanne 6₂ et on ouvre la vanne 6₃ et la vanne 14₁ et on met la pompe 10 en route. On remplit ainsi l'autoclave.
4. Arrivé à la pression de travail souhaitée (pression très supérieure à la pression de stockage, au moins 90 bars par exemple), on ouvre la vanne 16₁ et on régule le débit avec la vanne de régulation 16₂ pour maintenir la pression à la valeur souhaitée. Le CO₂ est éventuellement nettoyé dans le séparateur 18, puis il est liquéfié par les moyens 19 et renvoyé dans la réserve interne 6 pour être réutilisé.
5. En fin de traitement, on arrête la pompe 10 et on ferme la vanne 14₁. On continue de vider l'autoclave dans la réserve liquide 6, jusqu'à égalité des pressions pour perdre un minimum de CO₂
6. On ferme la vanne 16₁. La pression dans l'autoclave est alors de 60 bars.
7. On ouvre la vanne 14₂. Tout le CO₂, présent alors dans l'autoclave est perdu. Quand l'autoclave est à la pression atmosphérique, on peut ouvrir la porte 15 (ou, plus généralement, mettre en communication fluidique l'enceinte et l'atmosphère extérieure).

Pour cet exemple, les pertes sont de l'ordre de 0.2kg par litre d'autoclave (valeur qui peut varier en fonction de la température). La pompe 3 complète le stockage interne de la quantité perdue.

On considère maintenant un cycle d'une machine selon l'invention, telle que celle de la figure 2, avec un volume 20 de récupération égal à celui de l'autoclave 14.

Le cycle est le suivant (on suppose que le CO₂, est un gaz parfait et on néglige l'effet des variations de température lors des détentes).

Tout d'abord, on peut décrire un remplissage initial du volume 20 de récupération.

Dans ce cas, au départ du premier cycle le réservoir 20 de récupération est à la pression atmosphérique.

Toutes les vannes sont fermées, et la porte 15 de l'autoclave 14 est ouverte. Les étapes 1-6 décrites ci-dessus sont réalisées. Puis on procède aux étapes suivantes :
7. Ouverture de la vanne 20₁. Le CO₂ se répartit dans les deux volumes 14, 20, la pression résultante est de 30 bars.
8. Fermeture de la vanne 20₁.
9. On ouvre la vanne 14₂. Tout le CO₂ présent restant dans l'autoclave est perdu. Quand l'autoclave est à la pression atmosphérique, on peut ouvrir sa porte 15.

On a donc ouvert la vanne 14₂ à 30 bars, au lieu de 60 bars, soit 2 fois moins de pertes.

Au départ du deuxième cycle le réservoir de récupération 20 est donc à 30 bars.

Le cycle est alors le suivant.
1. Fermeture de la porte de l'autoclave et de la vanne 14₂, l'autoclave est donc à la pression atmosphérique.
2. Ouverture de la vanne 20₁, le CO₂, présent dans le réservoir de récupération se répartissant dans les deux volumes ; la pression résultante est de 15 bars.
3. Fermeture de la vanne 20₁ et ouverture de la vanne 6₃, de la vanne 14₁ et mise en route de la pompe 10. On remplit donc l'autoclave avec du fluide dense.
4. Les étapes 4 à 6 sont identiques à celles déjà décrites dessus.
7. Ouverture de la vanne 20₁. Le CO₂ se répartit dans les deux volumes; la pression résultante est de (60 + 15)/2 = 37,5 bars (volumes identiques).

Au départ du troisième cycle le réservoir de récupération est à 37,5/2 = 18,75 bars. Le cycle reste le même mais, à la fin, on ouvre l'autoclave à la pression de (60+18,75)2 = 39,4 bars.

La limite de pression dans le réservoir 20 est de 40 bars, soit une économie de CO₂ de 33%(=1-40/60).

Quel que soit le mode de réalisation envisagée, des moyens peuvent être prévus pour chauffer ou thermostater (ou maintenir à température constante) les deuxièmes moyens de stockage, de sorte que, ou afin que, le gaz qui y est stocké ne s'y condense pas et/ou ne s'y liquéfie pas.

Quel que soit le mode de réalisation envisagée, outre les moyens ci-dessus, un dispositif selon l'invention peut comporter des moyens 5, de type électronique et/ou informatique, pour contrôler et réguler le fonctionnement de chacun des composants de la machine, notamment les pompes et les vannes, selon une séquence d'étapes programmée.

Ces moyens 5 formant contrôleur peuvent comporter des circuits, qui permettent d'envoyer à chacun des composants de la machine les instructions et/ou les tensions permettant de le piloter suivant une séquence prédéfinie. En particulier, ces moyens vont permettre de mettre en oeuvre un cycle de nettoyage tel que décrit ci-dessus, et notamment de réguler les étapes de transfert de gaz entre l'autoclave et les moyens 20 de stockage en décharge. De manière plus précise, ces moyens vont commander les durées l'ouverture ou la fermeture des vannes 20₁, 16₁, 20₂, mais également des autres vannes du système, et/ou les durées de fonctionnement de la pompe 10 et/ou du compresseur 3.

Cet ensemble 5 peut en outre éventuellement recevoir des signaux correspondant à des mesures effectuées à l'aide d'un ou plusieurs capteurs de pression, par exemple disposées pour mesurer la pression dans l'autoclave 14, ou dans les moyens 20 de stockage, et peut les traiter et les utiliser pour le contrôle d'un ou plusieurs des composants de la machine.

Cet ensemble contrôleur 5 peut communiquer avec une interface utilisateur pour informer un utilisateur sur l'état de la machine, en particulier de son cycle de fonctionnement.

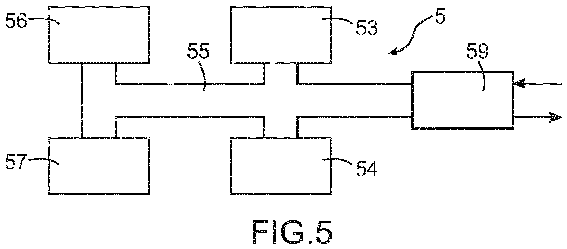

Un exemple de réalisation de ces moyens 5 est décrit ci-dessous de manière plus précise en liaison avec la figure 5.

Dans cet exemple, ces moyens comportent des moyens 53 de mémorisation pour mémoriser les instructions relatives aux traitements des données, par exemple pour effectuer un procédé du type décrit ci-dessus.

Selon un exemple de réalisation, le contrôleur 5 comporte une unité centrale, qui comprend elle-même un microprocesseur 56, un ensemble de mémoires non volatiles et RAM 57, des circuits périphériques, tous ces éléments étant couplés à un bus 55. Des données peuvent être stockées dans les zones mémoire, notamment des données pour mettre en oeuvre un procédé selon la présente invention ou pour contrôler une machine selon la présente invention. Des moyens 59 vont permettre de gérer le flux de données d'entrée et de sortie, à partir des autres composants de la machine, et en direction de celle-ci.

En variante, cet ensemble contrôleur 5 peut être réalisé sous forme de FPGA (Field Programmable Gate Array, ou circuit logique programmable) ou d'un ASIC (Application Specific Integrated Circuit ou circuit intégré spécialisé).

Les moyens 54, qui peuvent comporter des moyens de visualisation, peuvent éventuellement permettre à un utilisateur d'interagir avec le fonctionnement d'une machine selon l'invention, par exemple en intervenant sur une étape particulière d'un cycle de fonctionnement.

Un programme d'ordinateur peut comporter des instructions pour mettre en oeuvre un procédé selon l'invention, en particulier tel que décrit ci-dessus.

Un support de données, pouvant être lu par un système informatique, peut comporter des données, sous forme codée, pour mettre en oeuvre un procédé selon l'invention, en particulier tel que décrit ci-dessus.

Un produit logiciel peut comporter un moyen de support de données de programme, susceptible d'être lu par un système informatique, permettant de mettre en oeuvre un procédé selon l'invention, en particulier tel que décrit ci-dessus.

Une machine selon l'invention, et un procédé de fonctionnement d'une telle machine, tels que décrit ci-dessus, permet de réaliser une économie de composants, de durée de fonctionnement, et de matière utilisée.

L'invention a été décrite ci-dessus dans le cadre de la mise en oeuvre d'un fluide dense sous pression, notamment du dioxyde de carbone à l'état super critique. Elle peut s'appliquer à d'autres fluides, en particulier de l'azote ou de l'oxygène ou tout autre des fluides déjà cités.

L'invention a été décrite ci-dessus pour un procédé de nettoyage.

Mais d'autres procédés peuvent être mis en oeuvre à l'aide d'un dispositif ou d'un procédé selon l'invention, le fluide adéquat étant utilisé à l'état dense, ou même super-critique. Pour chacun des différents exemples cités ci-dessous, on peut utiliser du CO₂.

Dans tous les cas, le fluide utilisé, dense ou super-critique, vient baigner les pièces traitées. Le contact, plus ou moins long, entre ces dernières et le fluide provoque le traitement recherché.

C'est le cas, par exemple, d'un procédé de déliantage ou d'un procédé d'extraction (le nettoyage étant un cas particulier d'extraction).

Un procédé de déliantage permet d'extraire un liant d'une pièce réalisée en un alliage, par exemple à partir d'une poudre telle qu'une poudre assemblée dans une paraffine, et/ou d'extraire tout liant adapté à la fabrication de l'alliage.

Par exemple encore, un procédé d'extraction d'une ou plusieurs substances naturelles peut être mis en oeuvre en particulier dans l'industrie pharmaceutique ou agroalimentaire.

Un procédé d'extraction, ou encore de dégraissage, peut être mis en oeuvre également pour traiter de la laine naturelle, afin d'en extraire le suint. Habituellement, ce type de traitement est réalisé par du perchloréthylène ou de l'eau.

L'invention peut aussi être utilisée dans des procédés d'imprégnation ou d'apport de produit véhiculé par le fluide dense ou supercritique au sein du matériau à traiter.

L'invention permet également de mettre en oeuvre un procédé de stérilisation (par exemple dans le domaine agroalimentaire ou médical), à basse température, basé sur le pouvoir de pénétration du gaz, à haute pression, qui va pouvoir pénétrer dans la matière à traiter et aller neutraliser, ou tuer, des agents infectieux.

Plus généralement, tout type de pièces peut être traité par un procédé selon l'invention.

Les matériaux, qui peuvent être traités par le procédé de l'invention, sont généralement des matériaux solides, par exemple :
- des métaux,
- des alliages métalliques, éventuellement plaqués, comme l'aluminium, le titane, l'acier, l'acier inoxydable, le cuivre, le laiton, et tout autre alliage, ou métal plaqué,
- les matériaux céramiques, des matériaux polymères, des poudres, notamment des poudres des matériaux cités ci-dessus,
- des matériaux textiles, naturels ou synthétiques, ou encore du cuir,
- des boues de rectification, provenant par exemple d'un procédé de décolletage ou d'usinage.

Les pièces traitées peuvent être, par exemple :
- des pièces de l'industrie aéronautique, ou automobile et plus généralement des industries mécaniques,
- des pièces d'horlogerie et/ou de micromécanique,
- des connecteurs électriques ou électroniques,
- des composants en matériaux semi-conducteurs de l'industrie microélectronique,
- des appareils ou outils médicaux ou chirurgicaux, etc..
- des vêtements, ou des matériaux naturels utilisés dans l'industrie textile, par exemple de la laine, ou du cuir.

## Revendications

1. Dispositif de traitement par fluide dense, comportant :
a) une enceinte (14) de traitement, destinée à recevoir des pièces à traiter, et munie de moyens (15, 14₂) pour mettre en communication fluidique puis isoler l'intérieur de ladite enceinte par rapport à une atmosphère extérieure,
b) des moyens (6, 8) d'alimentation de ladite enceinte (14) en fluide dense, sous pression, comportant des premiers moyens (6) de stockage de fluide,
c) des deuxièmes moyens (20) de stockage, pour stocker, sous forme gazeuse, après une étape de traitement et avant mise en communication fluidique de l'enceinte avec une atmosphère extérieure, une partie du gaz contenu dans l'enceinte,
d) des moyens (20₁) pour mettre en communication fluidique ladite enceinte (14) de traitement et lesdits deuxièmes moyens (20) de stockage et permettre une circulation fluidique, de l'enceinte de traitement vers lesdits deuxièmes moyens de stockage puis, selon un trajet inverse, des deuxièmes moyens de stockage vers l'enceinte de nettoyage,
**caractérisé en ce que** le dispositif comporte :
e) des moyens spécialement programmés pour faire circuler, par différence de pression entre l'enceinte de traitement et les deuxièmes moyens de stockage, un fluide de l'enceinte de traitement vers lesdits deuxièmes moyens de stockage, puis, inversement, des deuxièmes moyens de stockage vers l'enceinte de traitement.

2. Dispositif selon la revendication 1, lesdits deuxièmes moyens de stockage (20) étant disposés en parallèle de moyens (16) qui permettent de détendre un gaz en sortie de ladite enceinte (14).

3. Dispositif selon la revendication 1, des moyens (16) qui permettent de détendre un gaz en sortie de ladite enceinte (14), étant disposés entre cette dernière et l'entrée desdits deuxièmes moyens de stockage (20).

4. Dispositif selon l'une des revendications 1 ou 2, le rapport entre le volume interne desdits deuxièmes moyens de stockage (20) et le volume interne de ladite enceinte (14) étant au moins égal à 1.

5. Dispositif selon l'une des revendications précédentes, comportant en outre des moyens (20₂) pour amener au moins une partie du fluide stocké dans les moyens de stockage vers les moyens (3, 6) d'alimentation de ladite enceinte (14) en fluide dense, sous pression.

6. Dispositif selon la revendication précédente, comportant en outre des moyens (5) pour amener au moins une partie du fluide stocké dans les moyens de stockage vers les moyens (3, 6) d'alimentation de ladite enceinte (14) en fluide dense pendant un cycle de traitement par l'enceinte de traitement.

7. Dispositif selon l'une des revendications précédentes, comportant en outre des moyens (23, 25) pour amener au moins une partie du fluide stocké dans les deuxièmes moyens de stockage (20) vers un ou plusieurs éléments à commande pneumatique.

8. Dispositif selon la revendication précédente, ledit ou lesdits éléments à commande pneumatique comportant au moins une vanne pneumatique et/ou un vérin pneumatique et/ou une pompe pneumatique.

9. Dispositif selon l'une des revendications précédentes, comportant en outre des moyens pour chauffer les deuxièmes moyens (20) de stockage.

10. Procédé de traitement par fluide dense, sous pression, comportant, dans cet ordre :
a) l'introduction d'au moins une 1^{ère} pièce ou élément à traiter, dans une enceinte (14), munie de moyens (15, 14₂) pour la mettre en communication fluidique avec une atmosphère extérieure, puis la fermeture de ces moyens (15, 14₂),
b) puis l'alimentation de ladite enceinte (14) en fluide dense, sous pression, et le traitement de ladite pièce,
c) puis le stockage, dans des moyens (20) de stockage, sous forme gazeuse à une pression P₂ inférieure à celle (P₁) qui existe dans l'enceinte, après l'étape b) de traitement et avant mise communication fluidique de l'intérieur de ladite enceinte avec l'atmosphère extérieure, d'une partie du gaz contenu dans l'enceinte de traitement,
d) la mise en communication fluidique de l'intérieur de ladite enceinte avec l'atmosphère extérieure,
e) l'introduction d'au moins une deuxième pièce à traiter dans ladite enceinte (14), puis la fermeture des moyens (15, 14₂) pour mettre en communication fluidique l'intérieur de l'enceinte avec l'atmosphère extérieure,
f) puis l'injection, dans ladite enceinte (14), d'au moins une partie du gaz stocké dans lesdits moyens (20) de stockage, le gaz contenu dans ladite enceinte (14) étant alors à une pression P₃ inférieure à la pression P₂ de stockage dans les moyens (20) de stockage.

11. Procédé selon la revendication 10, comportant en outre une injection d'une partie du gaz stocké dans lesdits moyens (20) de stockage dans des moyens (6) de stockage principaux, disposés en amont de moyen (8, 10, 12), pour amener un fluide dans un état dense, sous pression, par exemple au moins en partie pendant le traitement de ladite pièce.

12. Procédé selon l'une des revendications 10 ou 11, comportant en outre l'actionnement d'un ou plusieurs éléments à commande pneumatique à l'aide d'une partie du gaz stocké dans lesdits moyens (20) de stockage.

13. Procédé selon l'une des revendications 10 à 12, lesdits deuxièmes moyens de stockage (20) étant disposés en parallèle de moyens (16) qui permettent de détendre un gaz en sortie de ladite enceinte (14).

14. Procédé selon l'une des revendications 10 à 13, ladite pièce à traiter étant au moins en partie en un matériau métallique, et/ou en un alliage métallique, et/ou en matériau céramique, et/ou en un matériau semi-conducteur, et/ou en un matériau textile et/ou en un matériau naturel.

15. Procédé selon l'une des revendications 10 à 14, le traitement étant un traitement d'extraction, par exemple de nettoyage ou de dégraissage, ou de déliantage, ou de stérilisation.

## Patentansprüche

1. Vorrichtung zum Behandeln mit dichten, unter Druck, Fluiden, umfassend:
a) eine Behandlungskammer (14), welche dazu vorgesehen ist, zu behandelnde Stücke aufzunehmen, und welche mit Mitteln (15, 14₂) versehen ist, um das Innere der Kammer mit einer Umgebungsatmosphäre in Fluidverbindung zu versetzen und dann von ihr zu isolieren,
b) Mittel (6, 8) zum Versorgen der Kammer (14) mit dichtem, unter Druck, Fluid, umfassend erste Mittel (6) zum Speichern von Fluid,
c) zweite Mittel (20) zum Speichern für ein Speichern in Gasform nach einem Behandlungsschritt und vor einem Versetzen der Kammer in Fluidverbindung mit einer Umgebungsatmosphäre von einem Teil des in der Kammer enthaltenen Gases,
d) Mittel (20₁) zum Versetzen der Behandlungskammer (14) und der zweiten Mittel (20) zum Speichern in Fluidverbindung und zum Erlauben einer Fluidzirkulation von der Behandlungskammer zu den zweiten Mitteln zum Speichern, sowie anschließend von den zweiten Mitteln zum Speichern zu der Behandlungskammer entlang eines umgekehrten Weges,
**dadurch gekennzeichnet, dass** die Vorrichtung umfasst:
e) speziell zum Hervorrufen einer Zirkulation eines Fluids von der Behandlungskammer zu den zweiten Mitteln zum Speichern, sowie anschließend von den zweiten Mitteln zum Speichern zu der Behandlungskammer, durch Druckdifferenz zwischen der Behandlungskammer und den zweiten Mitteln zum Speichern programmierte Mittel.

2. Vorrichtung nach Anspruch 1, wobei die zweiten Speichermittel (20) parallel zu den Mitteln (16) angeordnet sind, welche ein Ablassen eines Gases an einem Ausgang der Kammer (14) erlauben.

3. Vorrichtung nach Anspruch 1, wobei die Mittel (16), welche das Ablassen eines Gases an einem Ausgang der Kammer (14) erlauben, zwischen letzterem und dem Eingang der zweiten Mittel zum Speichern (20) angeordnet sind.

4. Vorrichtung nach einem der Ansprüche 1 oder 2, wobei das Verhältnis zwischen dem Innenvolumen der zweiten Mittel zum Speichern (20) und dem Innenvolumen der Kammer (14) wenigstens gleich 1 ist.

5. Vorrichtung nach einem der vorhergehenden Ansprüche, ferner umfassend Mittel (20₂) zum Führen von wenigstens einem Teil des in den Mitteln zum Speichern gespeicherten Fluids zu den Mitteln (3, 6) zum Versorgen der Kammer (14) mit dichtem, unter Druck, Fluid.

6. Vorrichtung nach dem vorhergehenden Anspruch, ferner umfassend Mittel (5) zum Führen von wenigstens einem Teil des in den Mitteln zum Speichern gespeicherten Fluids zu den Mitteln (3, 6) zum Versorgen der Kammer (14) mit dichtem Fluid während eines Behandlungszyklus durch die Kammer zum Behandeln.

7. Vorrichtung nach einem der vorhergehenden Ansprüche, ferner umfassend Mittel (23, 25) zum Führen von wenigstens einem Teil des in den zweiten Mitteln zum Speichern (20) gespeicherten Fluids zu einem oder mehreren Pneumatik-Steuerelementen.

8. Vorrichtung nach dem vorhergehenden Anspruch, wobei das oder die Pneumatikelemente wenigstens ein pneumatisches Ventil und/oder einen pneumatischen Zylinder und/oder eine pneumatische Pumpe umfassen.

9. Vorrichtung nach einem der vorhergehenden Ansprüche, ferner umfassend Mittel zum Erhitzen der zweiten Mittel (20) zum Speichern.

10. Verfahren zum Behandeln mit dichten, unter Druck, Fluiden, in dieser Reihenfolge:
a) Eingeben wenigstens eines ersten zu behandelnden Stücks oder Elements in eine Kammer (14), welche mit Mittel (15, 14₂) zum Versetzen davon in Fluidverbindung mit einer Außenatmosphäre und einem anschließenden Schließen dieser Mittel (15, 14₂) versehen ist,
b) anschließendes Versorgen der Kammer (14) mit dichtem, unter Druck, Fluid und Behandeln des Stücks,
c) anschließendes Speichern in Mitteln (20) zum Speichern in Gasform bei einem Druck P₂ kleiner demjenigen (P₁), welcher in der Kammer vorliegt, nach dem Schritt b) des Behandelns und vor einem Versetzen des Inneren der Kammer in Fluidverbindung mit der Außenatmosphäre, eines Teils des in der Behandlungskammer enthaltenen Gases,
d) Versetzen des Inneren der Kammer in Fluidverbindung mit der Außenatmosphäre,
e) Eingeben von wenigstens einem zweiten zu behandelnden Stück in die Kammer (14), anschließend Schließen der Mittel (15, 14₂) zum Versetzen des Innenraums der Kammer in Fluidverbindung mit der Außenatmosphäre,
f) anschließend Eingeben von wenigstens einem Teil des in den Mitteln (20) zum Speichern gespeicherten Gases in die Kammer (14), wobei das in der Kammer (14) enthaltene Gas somit bei einem Druck P₃ kleiner als der Druck P₂ zum Speichern in den Mitteln (20) zum Speichern vorliegt.

11. Verfahren nach Anspruch 10, ferner umfassend eine Injektion von einem Teil des in den Mitteln (20) zum Speichern gespeicherten Gases in Mittel (6) zum hauptsächlichen Speichern, welche stromaufwärts der Mittel (8, 10, 12) angeordnet sind, um ein Fluid in einem dichten, unter Druck Zustand, beispielsweise wenigstens teilweise, während der Behandlung des Stücks zu führen.

12. Verfahren nach einem der Ansprüche 10 oder 11, ferner umfassend ein Betätigen von einem oder mehreren Pneumatik-Steuerelementen mit Hilfe eines Teils des in den Mitteln (20) zum Speichern gespeicherten Gases.

13. Verfahren nach einem der Ansprüche 10 bis 12, wobei die zweiten Mittel zum Speichern (20) parallel zu Mitteln (16) angeordnet sind, welche ein Ablassen eines Gases an einem Ausgang der Kammer (14) erlauben.

14. Verfahren nach einem der Ansprüche 10 bis 13, wobei das zu behandelnde Stück wenigstens teilweise aus einem metallischen Material und/oder einer metallischen Legierung und/oder einem keramischen Material und/oder einem Halbleiter-Material und/oder einem textilen Material und/oder einem natürlichen Material besteht.

15. Verfahren nach einem der Ansprüche 10 bis 14, wobei die Behandlung eine Extraktionsbehandlung ist, beispielsweise ein Reinigen oder ein Entfetten oder ein Entbindern oder eine Sterilisation.

## Claims

1. Treatment device using a dense fluid, comprising:
a) a treatment chamber (14), for receiving the parts to be treated, provided with means (15, 14₂) for establishing fluid communication then isolating the inside of said chamber with respect to the outer atmosphere,
b) means (6, 8) for supplying dense, pressurized fluid to said chamber (14), comprising first fluid storage means (6),
c) second storage means (20), for storing some of the gas contained in the chamber, in gaseous form, after a treatment step and before fluid communication is established between the chamber and the outer atmosphere,
d) means (20₁) for establishing fluid communication between said treatment chamber (14) and said second storage means (20) and for enabling fluid circulation, from the treatment chamber to said second storage means then, along a reverse path, from the second storage means to the treatment chamber,
**characterized in that** the device comprises :
e) means specially programmed to make, by pressure difference between the treatment chamber and the second storage means (20), a fluid circulate from the treatment chamber to said second storage means, then, conversely, from the second storage means to the treatment chamber.

2. Device according to claim 1, said second storage means (20) being arranged in parallel with the means (16), which make it possible to depressurise a gas at the outlet of said chamber (14).

3. Device according to claim 1, the means (16) that make it possible to depressurise a gas at the outlet of said chamber (14) being arranged between the latter and the inlet of said second storage means (20).

4. Device according to one of claims 1 or 2, the ratio between the internal volume of said second storage means (20) and the internal volume of said chamber (14) being at least equal to 1.

5. Device according to one of the preceding claims, moreover comprising means (20₂) for conveying at least some of the fluid stored in the storage means to the means (3, 6) for supplying said chamber (14) with dense, pressurized fluid.

6. Device according to the preceding claim, moreover comprising means (5) for conveying at least some of the fluid stored in the storage means to the means (3, 6) for supplying said chamber (14) with dense fluid during a treatment cycle by the treatment chamber.

7. Device according to one of the preceding claims, moreover comprising means (23, 25) for conveying at least some of the fluid stored in the second storage means (20) to one or more pneumatic control elements.

8. Device according to the preceding claim, said pneumatic control element or elements comprising at least a pneumatic valve and/or a pneumatic jack and/or a pneumatic pump.

9. Device according to one of the preceding claims, moreover comprising means for heating the second storage means (20).

10. Treatment method using a dense, pressurized fluid comprising, in this order:
a) the introduction of at least one first part or element to be treated into a chamber (14), provided with means (15, 14₂) for establishing fluid communication with the outer atmosphere, then closing these means (15, 14₂),
b) then the supply of dense, pressurized fluid to said chamber (14) and the treatment of said part,
c) then the storage of some of the gas contained in the treatment chamber, in the storage means (20), in gaseous form at a pressure P₂ lower than that (Pi) which exists in the chamber, after the treatment step b) and before fluid communication is established between the inside of said chamber and the outer atmosphere,
d) establishing fluid communication between the inside of said chamber and the outer atmosphere,
e) the introduction of at least one second part to be treated into said chamber (14), then closing the means (15, 14₂) for establishing fluid communication between the inside of the chamber and the outer atmosphere,
f) then the injection, into said chamber (14), of at least some of the gas stored in said storage means (20), the gas contained in said chamber (14) then being at a pressure P₃ lower than the storage pressure P₂ in the storage means (20).

11. Method according to claim 10, moreover comprising an injection of some of the gas stored in said storage means (20) into said main storage means (6), arranged upstream of the means (8, 10, 12), for bringing a fluid to the dense, pressurized state, for example at least in part during the treatment of said part.

12. Method according to one of claims 10 or 11, moreover comprising the actuation of one or more pneumatic control elements using some of the gas stored in said storage means (20).

13. Method according to one of claims 10 to 12, said second storage means (20) being arranged in parallel with the means (16) that make it possible to depressurise a gas at the outlet of said chamber (14).

14. Method according to one of claims 10 to 13, said part to be treated being at least in part made of a metal material, and/or a metal alloy, and/or a ceramic material, and/or a semiconductor material, and/or a textile material and/or a natural material.

15. Method according to one of claims 10 to 14, the treatment being an extraction treatment, for example cleaning or degreasing, or debinding, or sterilisation.
